# EUROPEAN PATENT APPLICATION

(11) **EP 2 109 149 A1**
(43) Date of publication of application: **14.10.2009**
(21) Application number: 07860348.7
(22) Date of filing: 27.12.2007
(51) Int. Cl.: H01L 31/042, H01L 31/04

(54) **SOLAR BATTERY CELL, SOLAR BATTERY ARRAY, SOLAR BATTERY MODULE AND METHOD FOR MANUFACTURING SOLAR BATTERY ARRAY**

(30) Priority: 25.01.2007 JP 2007015143
(71) Applicant: Sharp Kabushiki Kaisha, Osaka-shi, Osaka 545-8522 (JP)
(72) Inventor: FUNAKOSHI, Yasushi, Osaka 545-8522 (JP)
(74) Representative: Müller - Hoffmann & Partner
(86) International application number: PCT/JP2007/075126
(87) International publication number: WO 2008/090718

(57) **Abstract**

There is provided a solar cell array and a solar cell module including the solar cell array, comprising: a solar cell wafer (10) including a semiconductor substrate (1) and a p electrode (11) and an n electrode (12) provided at a surface of the semiconductor substrate (1); an interconnection substrate (38) including an insulating substrate (36) having a light receiving surface and a p interconnection (34) and an n interconnection (35) provided at the light receiving surface and electrically insulated from each other, on the interconnection substrate (38), more than one solar cell wafer (10) being disposed adjacently, the p electrode (11) and the p interconnection (34) being electrically connected, the n electrode (12) and the n interconnection (35) being electrically connected; and an interconnection (32) formed such that the p interconnection (34) electrically connected to one solar cell wafer (10) and the n interconnection (35) electrically connected to another solar cell wafer (10) adjacent to one solar cell wafer (10) are electrically connected at the light receiving surface and a surface opposite thereto.

## Description

### TECHNICAL FIELD

The present invention relates generally to solar cells and solar cell arrays that have high characteristics as solar cell modules, and methods of fabricating the same. The present invention also relates to solar cell modules formed of a plurality of such solar cells and solar cell arrays that are sealed.

### BACKGROUND ART

Development of clean energy has recently been desired in view of the problem of exhaustion of energy resources and the global environment problem such as increase of CO₂ in the air, and photovoltaic power generation employing solar cell wafers has been developed and put into practice as a new energy source, and is now on the way to progress.

A conventional mainstream solar cell wafer for example includes a single-crystalline or polycrystalline silicon substrate having a light receiving surface having an impurity of a conduction type opposite to that of the silicon substrate diffused therein to provide a pn junction, and electrodes provided at the light receiving surface and a surface of the silicon substrate opposite to the light receiving surface, respectively. It is also generally done to diffuse an impurity of the same conduction type as the silicon substrate in the silicon substrate at the back surface at a high concentration to provide high output depending on a back surface field effect.

Furthermore, a so-called back surface contact solar cell wafer including a silicon substrate that has a light receiving surface without having an electrode and has a back surface having a pn junction, is developed (See U.S.P. 4,927,770 (Patent Document 1)). The back surface contact solar cell wafer, generally having no electrode on the light receiving surface, has no shadow loss resulting from an electrode, and can be expected to provide an output higher than the aforementioned solar cell wafer having electrodes on a silicon substrate at a light receiving surface and a back surface, respectively. The back surface contact solar cell wafer is applied to a solar car or a concentrating solar cell module through such properties and also developed in recent years for housing. Furthermore, if it has a silicon substrate reduced in thickness, it does not have a characteristic impaired as a solar cell wafer in comparison with a solar cell wafer having a pn junction at a light receiving surface. It can thus require a small amount of silicon used per watt, and a reduced cost for source materials can be expected.

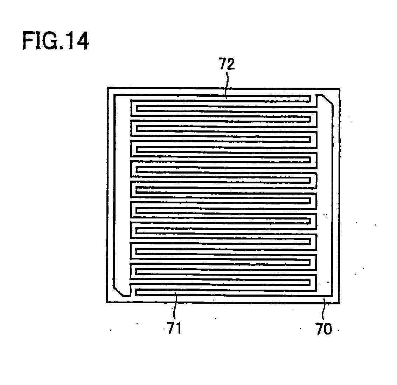

Fig. 14 is a plan view of a conventional back surface contact solar cell wafer as seen at its back surface. On a silicon substrate 70 a p electrode 71 and an n electrode 72 are each deposited in the form of a comb. A plurality of back surface contact solar cell wafers are connected by an interconnector to fabricate the back surface contact solar cell string, and to do so, it is proposed that the interconnector is connected to the Fig. 14 comb p electrode 71 and n electrode 72 at a bus bar electrode portion (see Japanese Patent Laying-open No. 2005-011869 (Patent Document 2)).

Furthermore, to fabricate inexpensively a back surface contact solar cell and back surface contact solar cell module having a further higher fill factor (F.F), there has also been proposed a method of connecting a p electrode and an n electrode of a solar cell wafer to an interconnection substrate previously provided with a p interconnection and an n interconnection corresponding the p electrode and the n electrode, respectively (see Japanese Patent Laying-open No. 2005-340362 (Patent Document 3)).
Patent Document 1: U.S.P. 4,927,770
Patent Document 2: Japanese Patent Laying-open No. 2005-011869
Patent Document 3: Japanese Patent Laying-open No. 2005-340362

### DISCLOSURE OF THE INVENTION

### PROBLEMS TO BE SOLVED BY THE INVENTION

Connecting an interconnector to the Fig. 14 p electrode 71 and n electrode 72 at a bus bar electrode portion requires that a space for the interconnector be ensured in the back surface contact solar cell wafer fabricated. Furthermore, when a plurality of strings is connected to fabricate a back surface contact solar cell array, interconnecting the strings provides reduced F.F. Fabricating a back surface contact solar cell array with reduction in F.F suppressed requires that a large space be ensured for the interconnector. A larger space for the interconnector, however, results in the fabricated back surface contact solar cell wafer having its area with a solar cell wafer, which actually contributes to power generation, occupying a reduced area.

Furthermore, if the interconnector is connected to the Fig. 14 comb p electrode 71 and n electrode 72 at a bus bar electrode portion to connect a plurality of back surface contact solar cell wafers in series to fabricate a back surface contact solar cell string, a large current is generated. To overcome this disadvantage, Patent Document 3 proposes a method. In this method, however, an interconnection substrate has a p interconnection and an n interconnection in the form of a comb, whereas a solar cell wafer has a p electrode and an n electrode in the form of a dot, and in connecting by reflow, the solar cell wafer and the interconnection substrate are occasionally displaced in various directions.

Accordingly the present invention contemplates a solar cell array and solar cell module that has a solar cell wafer occupying a large area relative to that of the solar cell array and solar cell module and can thus achieve high module efficiency. Furthermore, the present invention also contemplates a method of fabricating a solar cell array with a solar cell wafer and an interconnection substrate less displaceable in various directions when they are connected by reflow.

### MEANS FOR SOLVING THE PROBLEMS

The present invention relates to a first solar cell array comprising: a solar cell wafer including a semiconductor substrate and a p electrode and an n electrode provided at a surface of the semiconductor substrate; an interconnection substrate including an insulating substrate having a light receiving surface and a p interconnection and an n interconnection provided at the light receiving surface and electrically insulated from each other, on the interconnection substrate, more than one solar cell wafer being disposed adjacently, the p interconnection and the n interconnection being provided at the surface of the insulating substrate to correspond in number to the solar cell wafer disposed, the p electrode and the p interconnection being electrically connected, the n electrode and the n interconnection being electrically connected; and an interconnection that includes an interconnection formed such that the p interconnection electrically connected to one solar cell wafer and the n interconnection electrically connected to another solar cell wafer adjacent to one solar cell wafer are electrically connected and that is formed such that the p interconnection and the n interconnection are also provided at a surface of the insulating substrate opposite to the light receiving surface and electrically connected at the surface opposite.

Furthermore, the first solar cell array preferably comprises an interconnection formed such that the p interconnection and the n interconnection are at least partially passed through the insulating substrate via a through hole and thus provided at the surface of the insulating substrate opposite to the light receiving surface, and electrically connected at the surface opposite.

Furthermore in the first solar cell array preferably the p interconnection and the n interconnection are formed of a material including at least one of copper, aluminum and silver, and the p electrode and the p interconnection are connected using one of solder and a conductive adhesive and so are the n electrode and the n interconnection.

Furthermore in the first solar cell array preferably a pattern forming the p electrode substantially overlays a pattern forming the p interconnection when the pattern forming the p electrode and the pattern forming the p interconnection are electrically connected, and a pattern forming the n electrode substantially overlays a pattern forming the n interconnection when the pattern forming the n electrode and the pattern forming the n interconnection are electrically connected.

Furthermore, the present invention relates to a second solar cell array comprising: a plurality of solar cells disposed adjacently, each formed of a single solar cell wafer including a semiconductor substrate and a p electrode and an n electrode provided at a surface of the semiconductor substrate, and a single interconnection substrate including an insulating substrate having a light receiving surface and a p interconnection and an n interconnection provided at the light receiving surface and electrically insulated from each other, the p electrode and the p interconnection being electrically connected, the n electrode and the n interconnection being electrically connected; and an interconnection that includes an interconnection formed such that the p interconnection of one solar cell and the n interconnection of the solar cell adjacent to one solar cell are electrically connected and that is formed such that the p interconnection and the n interconnection are electrically connected at the surface opposite of the insulating substrate.

Furthermore the second solar cell array preferably comprises an interconnection formed such that the p interconnection and the n interconnection of the solar cell pass through the insulating substrate via a through hole and are thus provided at the surface of the insulating substrate opposite to the light receiving surface, and electrically connected at the surface opposite of the insulating substrate.

Furthermore in the second solar cell array preferably the p interconnection and the n interconnection are formed of a material including at least one of copper, aluminum and silver, and the p electrode and the p interconnection are connected using one of solder and a conductive adhesive and so are the n electrode and the n interconnection.

Furthermore in the second solar cell array preferably the solar cell is provided such that: a pattern forming the p electrode substantially overlays a pattern forming the p interconnection when the pattern forming the p electrode and the pattern forming the p interconnection are electrically connected; and a pattern forming the n electrode substantially overlays a pattern forming the n interconnection when the pattern forming the n electrode and the pattern forming the n interconnection are electrically connected.

Furthermore, the present invention relates to a third solar cell array comprising: first solar cell arrays, as described above, disposed adjacently; and an interconnection formed such that a p interconnection of one first solar cell array and an n interconnection of the first solar cell array adjacent to one first solar cell array are electrically connected.

Furthermore, the present third solar cell array comprises: first solar cell arrays disposed adjacently; and an interconnection formed such that a p interconnection of one first solar cell array and an n interconnection of the first solar cell array adjacent to one first solar cell array are electrically connected at the surface opposite of the insulating substrate.

Furthermore, the present invention relates to a solar cell comprising: a solar cell wafer including a semiconductor substrate and a p electrode and an n electrode provided at a surface of the semiconductor substrate; and an interconnection substrate including an insulating substrate having a light receiving surface and a p interconnection and an n interconnection provided at the light receiving surface and electrically insulated from each other, the p electrode and the p interconnection being electrically connected at the light receiving surface of the insulating substrate, the n electrode and the n interconnection being electrically connected at the light receiving surface of the insulating substrate, the p interconnection and the n interconnection being also provided at a surface of the insulating substrate opposite to the light receiving surface.

Furthermore in the solar cell the p interconnection and the n interconnection pass through the insulating substrate via a through hole and are thus provided at the surface of the insulating substrate opposite to the light receiving surface.

Furthermore in the solar cell preferably the p interconnection and the n interconnection are formed of a material including at least one of copper, aluminum and silver, and the p electrode and the p interconnection are electrically connected using one of solder and a conductive adhesive and so are the n electrode and the n interconnection.

Furthermore in the solar cell preferably a pattern forming the p electrode substantially overlays a pattern forming the p interconnection when the pattern forming the p electrode and the pattern forming the p interconnection are electrically connected, and a pattern forming the n electrode substantially overlays a pattern forming the n interconnection when the pattern forming the n electrode and the pattern forming the n interconnection are electrically connected.

Furthermore in the solar cell preferably a pattern forming the p electrode and a pattern of the p interconnection formed at the light receiving surface of the insulating substrate are identical; and a pattern forming the n electrode and a pattern of the n interconnection formed at the light receiving surface of the insulating substrate are identical.

Furthermore in the solar cell preferably the p electrode and the n electrode are provided at one surface of the solar cell wafer.

Furthermore in the solar cell preferably the p electrode and the n electrode are formed in a pattern such that the p electrode and the n electrode are formed in combs, respectively, each having one linear electrode and a toothed electrode having a plurality of teeth intersecting the linear electrode perpendicularly and the p electrode and the n electrode have their respective toothed electrodes facing each other, with their respective teeth arranged along one surface of the semiconductor substrate alternately.

Furthermore in the solar cell preferably the semiconductor substrate is a silicon substrate having a thickness equal to or smaller than 200 µm.

Furthermore the present invention relates to a method of fabricating the first solar cell array as described above, employing a reflow furnace for connection using one of the solder and the conductive adhesive.

Furthermore, the present invention relates to a method of fabricating the second solar cell array as described above, employing a reflow furnace for connection using one of the solder and the conductive adhesive.

Furthermore, the present invention relates to a solar cell module formed of the first solar cell array, the second solar cell array, the third solar cell array, or the solar cell, as described above, sealed with resin and a protection substrate.

### EFFECTS OF THE INVENTION

The present invention can thus provide a solar cell array, solar cell module and solar cell that can achieve high yield and high conversion efficiency (high module efficiency).

### BRIEF DESCRIPTION OF THE DRAWINGS

Fig. 1 is a cross section of a preferred embodiment of a first solar cell array of the present invention.
Fig. 2 is a plan view of the preferred embodiment of the first solar cell array of the present invention, as seen at its light receiving surface.
Fig. 3 is a plan view of a preferred embodiment of an interconnection substrate for the first solar cell array of the present invention, as seen at its light receiving surface.
Fig. 4 is a cross section of a preferred embodiment of a second solar cell array of the present invention.
Fig. 5 is a plan view of the preferred embodiment of the second solar cell array of the present invention, as seen at its back surface.
Fig. 6 is a plan view of a preferred embodiment of a third solar cell array of the present invention, as seen at its light receiving surface.
Fig. 7 is a plan view of a preferred embodiment of a solar cell of the present invention, as seen at its light receiving surface.
Fig. 8A is a cross section taken along a line VIIIA-VIIIA of Fig. 7 and Fig.8B is a cross section taken along a line VIIIB-VIIIB of Fig. 7.
Fig. 9 is a cross section of another embodiment of the interconnection substrate of the present invention.
Fig. 10A is a plan view of a preferred embodiment of a solar cell wafer of the present invention, as seen at its back surface, and Fig. 10B is a plan view of a preferred embodiment of an interconnection substrate of the present invention, as seen at its light receiving surface.
Fig. 11 represents a process of a method of fabricating a solar cell wafer of the present invention in one embodiment.
Fig. 12 is a cross section for illustrating each step of the process of the method of fabricating the solar cell wafer of the present invention in one embodiment.
Fig. 13 is a cross section of a preferred embodiment of a solar cell module of the present invention.
Fig. 14 is a plan view of a conventional solar cell wafer at its back surface.
Fig. 15 is a plan view of a conventional solar cell wafer serving as a first comparative example, as seen at its back surface.
Fig. 16 is a plan view of a conventional solar cell array serving as a second comparative example, as seen at its back surface.

### DESCRIPTION OF THE REFERENCE SIGNS

1: semiconductor substrate, 2: antireflection film, 3: passivation film, 4: texture structure, 5: p+ layer, 6: n+ layer, 7: texture mask, 8: diffusion mask, 10, 90: solar cell wafer, 11, 71: p electrode, 12, 72: n electrode, 13, 33: alignment mark, 14, 24, 34: p interconnection, 15, 25, 35: n interconnection, 16, 26, 36, 61: insulating substrate, 18, 28, 38, 51: interconnection substrate, 19, 39, 49: solder, 20: solar cell, 30, 60: first solar cell array, 32: interconnection, 37, 47, 52, 62, 77: interconnector, 40: second solar cell array, 50: third solar cell array, 70: silicon substrate, 80: solar cell module, 81: glass substrate, 82: weatherproof film, 83: resin.

### BEST MODES FOR CARRYING OUT THE INVENTION

In the present specification, a surface of a member of a solar cell and first solar cell array on which sunlight is incident serves as a light receiving surface. Furthermore, a surface that is opposite to the light receiving surface and on which sunlight is not incident serves as a back surface. The present invention provides a solar cell, a first solar cell array, a second solar cell array and a third solar cell array, which are preferably a back surface electrode type solar cell wafer including a solar cell wafer having one surface, a back surface in particular, having a p electrode and an n electrode.

Hereinafter the present invention will be described in embodiments. In the figures, identical or corresponding components are identically denoted.

### [First Solar cell Array]

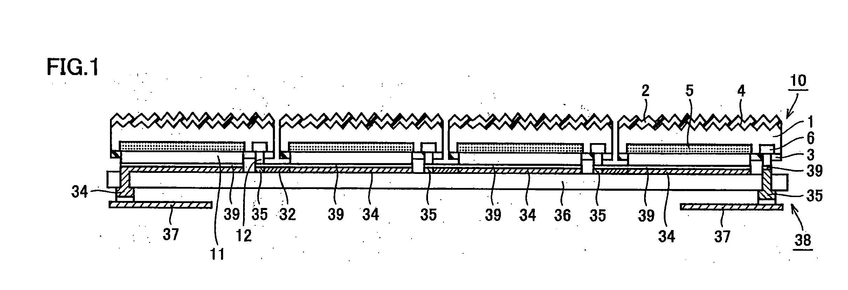

Fig. 1 is a cross section of a preferred embodiment of a first solar cell array of the present invention. In the present invention, the first solar cell array is formed of a single interconnection substrate 38 and two or more solar cell wafers 10 provided on interconnection substrate 38 and electrically connected together. Furthermore, a plurality of solar cell wafers 10 connected in one row in series and attached to interconnection substrate 38 will hereinafter be referred to as a string. Fig. 1 shows a string including four solar cell wafers 10.

Interconnection substrate 38 includes an insulating substrate 36 and a p interconnection 34 and an n interconnection 35 provided on insulating substrate 36 at a surface closer to a light receiving side and electrically insulated from each other. Solar cell wafer 10 has a p electrode 11 and an n electrode 12 electrically connected to p interconnection 34 and n interconnection 35, respectively, via solder 39. N interconnection 35 that one solar cell wafer 10 is electrically connected to is electrically connected to p interconnection 34 that an adjacent solar cell wafer 10 is connected to via an interconnection 32 provided on insulating substrate 36 at the light receiving surface. Furthermore, p interconnection 34 electrically connected to one solar cell wafer 10 disposed on interconnection substrate 38 is electrically connected to n interconnection 35 connected to another solar cell wafer adjacent to that one solar cell wafer 10 by interconnection 32 provided on insulating substrate 36 at the light receiving surface. The string has opposite ends with p interconnection 34 and n interconnection 35 passing through insulating substrate 36 via through holes and thus also provided at a back surface of insulating substrate 36. P interconnection 34 located at an end of the string and appearing at the back surface of insulating substrate 36 and n interconnection 35 located at an end of another string can be connected via an interconnector 37 serving as an interconnection to electrically connect the entirety of the first solar cell array. P interconnection 34 and n interconnection 35, and interconnector 37 can be connected for example using solder, and interconnector 37 is connected to p interconnection or n interconnection provided at a back surface of insulating substrate 36 of another string. In other words, strings are electrically interconnected at a back surface of an insulating substrate.

Conventionally, in interconnecting the first solar cell array, its geometrical constraints often prevent ensuring a sufficient width (or area in cross section) for an interconnector serving as interconnection for interconnecting strings, which serves as a factor decreasing the first solar cell array in fill factor (F.F). In the present invention the first solar cell array allows strings to be interconnected by an interconnector provided at a back surface of an insulating substrate. This can eliminate the necessity of providing a space for a material for interconnection between the strings. The first solar cell array can thus have solar cell wafers packed more densely, and achieve higher module efficiency than conventional.

Furthermore in accordance with the present invention it is no longer necessary to worry that interconnector 37 may contact solar cell wafer 10, however interconnector 37 may be increased in width, as solar cell wafer 10 exists opposite to interconnector 37 with insulating substrate 36 posed therebetween, and interconnector 37 can be used that has a sufficient width (or area in cross section) to prevent reduced F.F.

Herein, solar cell wafer 10 is formed with a semiconductor substrate 1, such as a silicon substrate, serving as a material. Solar cell wafer 10 is formed as semiconductor substrate 1 undergoes a variety of processes, as will be described hereinafter. Solar cell wafer 10 has a back surface provided with a plurality of p+ layers 5 and a plurality of n+ layers 6 alternately spaced. On p+ layer 5 and n+ layer 6 are deposited p electrode 11 and n electrode 12. P electrode 11 and n electrode 12 are formed preferably of metallic material, silver in particular. Furthermore, solar cell wafer 10 at its back surface other than a portion having p electrode 11 and n electrode 12 is covered with passivation film 3. Furthermore, solar cell wafer 10 has a light receiving surface having a texture structure 4 and covered with antireflection film 2.

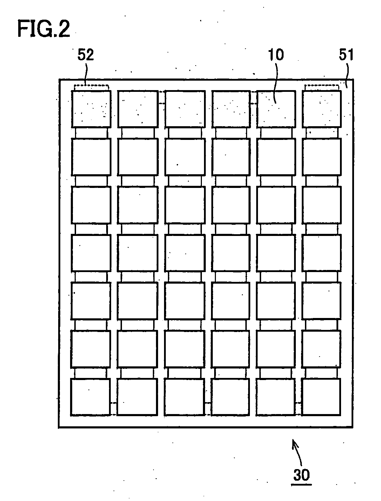

Fig. 2 is a plan view of the preferred embodiment of the first solar cell array of the present invention, as seen at its light receiving surface. Preferably, solar cell wafers 10 on an interconnection substrate 51 are connected in series. With reference to Fig. 2, the first solar cell array is shown in one example. Interconnection substrate 51 is previously prepared that is formed of an insulating substrate and p interconnection and n interconnection provided on the insulating substrate to allow several tens of solar cell wafers 10 to be electrically connected in series, and on interconnection substrate 51 solar cell wafers 10 are disposed and electrically connected. A row of 7 solar cell wafers 10 are connected by an interconnection provided at a light receiving surface of the insulating substrate, and 6 rows of strings are thus formed. Each string has ends with p interconnection and n interconnection passing through the insulating substrate via throughholes and connected at a back surface of the insulating substrate by an interconnector 52 electrically.

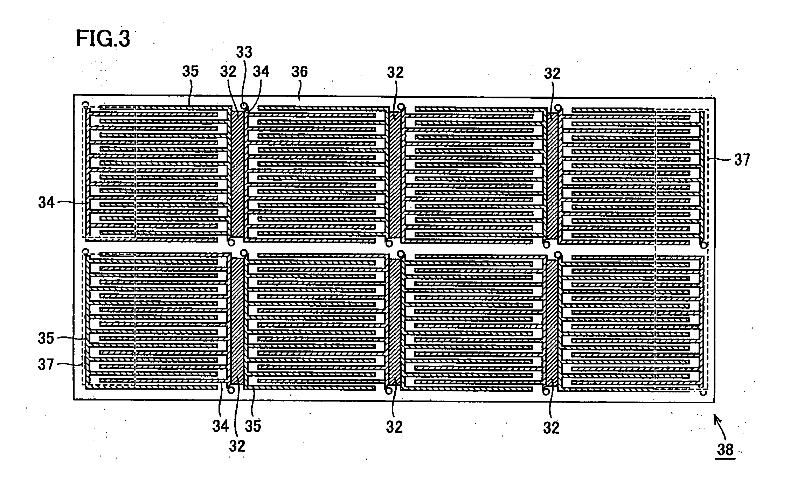

Fig. 3 is a plan view of a preferred embodiment of an interconnection substrate for the first solar cell array of the present invention, as seen at its light receiving surface. An interconnection substrate 38 includes insulating substrate 36 and p interconnection 34 and n interconnection 35 provided thereon for electrical connection to a plurality of solar cell wafers. P interconnection 34 and n interconnection 35 are connected by interconnection 32 on insulating substrate 36.

Fig. 3 shows that two strings each formed of four solar cell wafers connected in one row are electrically connected by interconnector 37. In other words, interconnection substrate 38 has p interconnection 34 and n interconnection 35 provided to be capable of connecting 8 solar cell wafers. Each string has opposite ends with p interconnection 34 and n interconnection 35 passed through insulating substrate 36 via throughholes and thus also provided at a back surface of insulating substrate 36. P interconnection 34 located at an end of a string and appearing at the back surface of insulating substrate 36 can be connected to n interconnection 35 of an end of another string by interconnector 37.

P interconnection 34 and n interconnection 35 are preferably formed of a material including at least one of copper, aluminum and silver. Herein, interconnection 32 may be formed of a material identical to or different from that of p interconnection 34 and n interconnection 35. If interconnection 32 is formed of a material identical to that of p interconnection 34 and n interconnection 35, p interconnection 34, interconnection 32, and n interconnection 35 may be formed for example as a series of interconnection.

Furthermore, insulating substrate 36 can be implemented for example as a glass substrate, a glass epoxy substrate, a glass composite substrate, a paper epoxy substrate, a paper phenol substrate, polyethylene terephthalate (PET) film, polyethylene naphthalate (PEN) film, polyimide (PI) film or the like. More preferably, insulating substrate 36 is implemented as an approximately 0.5-2 mm glass substrate or glass epoxy substrate, as it can reinforcement thin, fragile solar cell wafer 10. Preferably, p interconnection 34 and n interconnection 35 are formed to substantially overlay patterns forming p electrode 11 and n electrode 12 of solar cell wafer 10.

Furthermore, p interconnection 34 and n interconnection 35 can for example be copper foil, aluminum foil, silver foil, these foils and Invar (Fe-Ni alloy) deposited in layers to provide metallic foil providing adjustment in thermal expansion, or conductive paste including at least one of copper, aluminum and silver or the like for example printed in a desired pattern on insulating substrate 36. In doing so, a pattern of interconnection 32 and p interconnection 34 and/or n interconnection 35 that are connected together, as described above, may thus be printed. Furthermore, p interconnection 34 and n interconnection 35 can be formed with a thickness and a pattern line width appropriately adjusted and set. Furthermore, interconnection substrate 38 is provided at the light receiving surface with an alignment mark 33 to prevent a solar cell wafer and interconnection substrate 38 from having their connection displaced.

Note that p interconnection 34 and n interconnection 35 may be folded back at an end of insulating substrate 36 and thus provided at a back surface of insulating substrate 36.

Herein, the first solar cell array is fabricated in a method including for example a process for fabricating solar cell wafer 10, a process for fabricating interconnection substrate 38, and a process for electrically connecting solar cell wafer 10 and interconnection substrate 38. These processes can be provided in a method similar to that of fabricating a solar cell wafer and a solar cell cell, as will be described hereinafter. It should be noted, however, that if solar cell wafer 10 and interconnection substrate 38 are connected in a process employing a reflow furnace and using solder or conductive adhesive, it is necessary to consider the reflow furnace's internal temperature distribution. The method of fabricating the first solar cell array, as described above, allows several tens of solar cell wafers and an interconnection substrate to be connected in a reflow furnace at a time, and a first solar cell array having a high F.F can be fabricated in a short period of time.

Furthermore, preferably, when a p electrode 11 forming pattern and a p interconnection 34 forming pattern are electrically connected, the p electrode 11 forming pattern substantially overlays the p interconnection 34 forming pattern, and when an n electrode 12 forming pattern and an n interconnection 35 forming pattern are electrically connected, the n electrode 12 forming pattern substantially overlays the n interconnection 35 forming pattern, because a self alignment effect can prevent solar cell wafer 10 from being offset from the position of an interconnection substrate in a reflow furnace when they are connected using solder. Note that p electrode 11 and n electrode 12 may be formed for example in the form of a dot.

### [Second Solar Cell Array]

Hereinafter in the present invention a solar cell refers to what with a single solar cell wafer electrically connected for a single independent interconnection substrate. The solar cell's structure will be described later in detail.

Furthermore in the present invention a second solar cell array refers to a solar cell array that includes a plurality of solar cells disposed mutually adjacently and an interconnection formed with one solar cell's p interconnection and an adjacent solar cell's n interconnection electrically connected together.

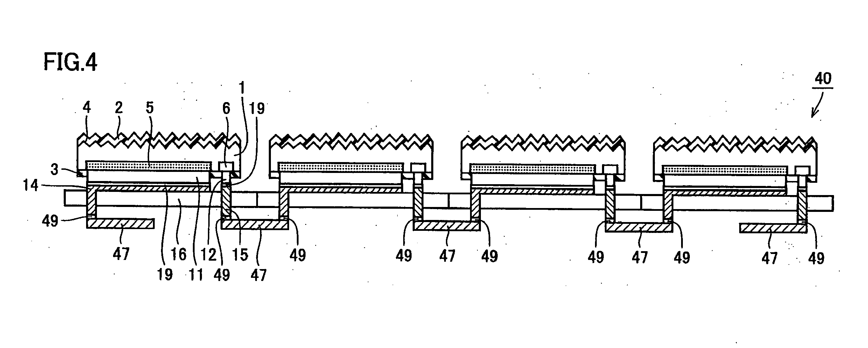

Fig. 4 is a cross section of a preferred embodiment of a second solar cell array of the present invention. A second solar cell array 40 includes a solar cell having a p interconnection 14 and an n interconnection 15 each provided at a back surface of an insulating substrate 16 as an output extracting terminal. One solar cell's p interconnection 14 and another solar cell's n interconnection 15 are connected via an interconnector 47 in series to fabricate second solar cell array 40. Interconnector 47 and p interconnection 14 and n interconnection 15 are connected preferably using solder 49.

Conventionally in interconnecting the second solar cell array the solar cell's geometrical constraints often prevent ensuring a sufficient width (or area in cross section) for an interconnector for connection, which serves as a factor decreasing the second solar cell array in fill factor (F.F). In accordance with the present invention the second solar cell array eliminates the necessity of worrying that interconnector 47 may contact solar cell wafer 10, however interconnector 47 may be increased in width, as solar cell wafer 10 exists opposite to interconnector 47 with insulating substrate 16 posed therebetween. An interconnector can thus be used that has a sufficient width (or area in cross section) to prevent reduced F.F.

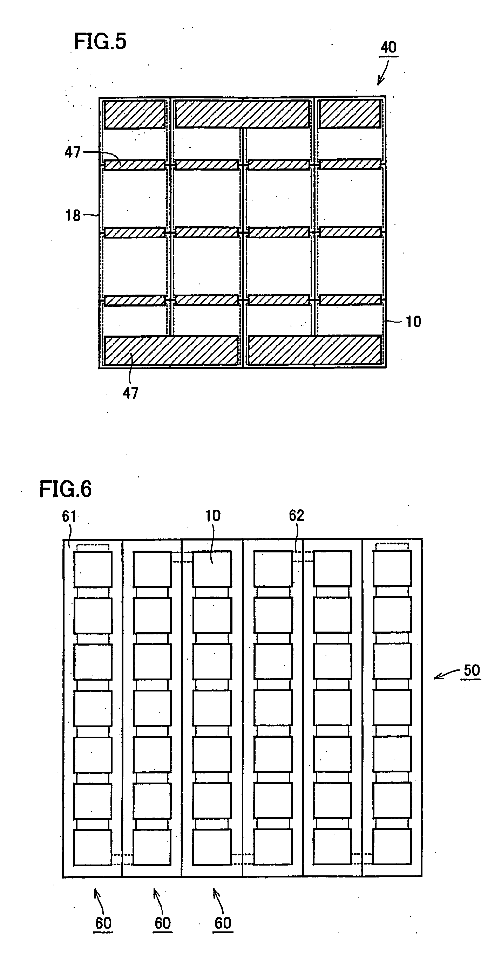

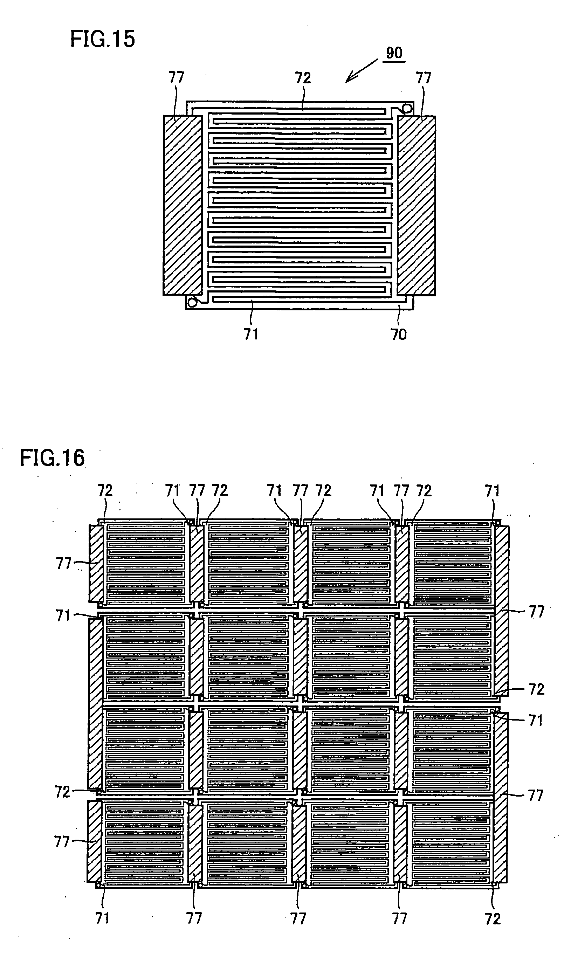

Fig. 5 is a plan view of the preferred embodiment of the second solar cell array of the present invention, as seen at its back surface. Solar cell 10 has p interconnection and n interconnection brought to a back surface of insulating substrate 16 as an output extracting terminal, as has been described previously, and, as shown in Fig. 5, the p interconnection and the n interconnection are each electrically connected at the back surface of insulating substrate 16 by interconnector 47. In Fig. 5, 16 solar cells 10 are electrically connected in series to form second solar cell array 40. When the Fig. 5 second solar cell array 40 has its several tens of connected solar cells 10 for example undergoing an inspection process and a solar cell 10 is found to have a problem, second solar cell array 40 facilitates exchanging that defective solar cell 10, since the defective solar cell 10 can be removed simply by removing interconnector 47 that connects the defective solar cell 10.

For example, a solar cell 20 is completed for example by electrically connecting solar cell wafer 10 and an interconnection substrate for example in a reflow furnace using solder or with conductive adhesive. P interconnection 14 and n interconnection 15 are preferably formed of a material including at least one of copper, aluminum and silver.

### [Third Solar Cell Array]

In the present invention a third solar cell array refers to the following two forms:
(1) a solar cell array in which a plurality of first solar cell arrays are adjacently disposed and a p interconnection electrically connected to one first solar cell array and an n interconnection electrically connected to an adjacent first solar cell array are electrically connected together to provide an interconnection; and
(2) a solar cell array in which a plurality of solar cells and first solar cell arrays are mixed together and adjacently disposed and adjacent solar cells and/or first solar cell arrays have their p and n interconnections electrically connected together to provide an interconnection.

More specifically, the third solar cell array refers to a plurality of first solar cell arrays each fabricated of a solar cell wafer and an interconnection substrate connected using solder or conductive adhesive, or a plurality of sets each of the first solar cell array and solar cells mixed together, that are electrically connected together.

Fig. 6 is a plan view of a preferred embodiment of a third solar cell array of the present invention, as seen at its light receiving surface. In Fig. 6 a third solar cell array 50 is provided as follows: previously, a plurality of first solar cell arrays 60 are prepared. Each array is a string including for example 7 solar cell wafers 10. The plurality of first solar cell arrays 60 are disposed adjacently, and adjacent first solar cell arrays 60 have their respective insulating substrates 61 having their respective back surfaces having their respective ends having p and n interconnections electrically connected by an interconnector 62. Such third solar cell array 50 allows a simpler fabrication process than second solar cell array 40 formed of a plurality of solar cells 10 connected together, as described above. Furthermore, in comparison with the first solar cell array formed of several tens of solar cell wafers, a plurality of first solar cell arrays in the form of strings that are connected together allows a reflow furnace having a reduced width to be used. This facilitates controlling the reflow furnace's temperature distribution.

### [Solar Cell]

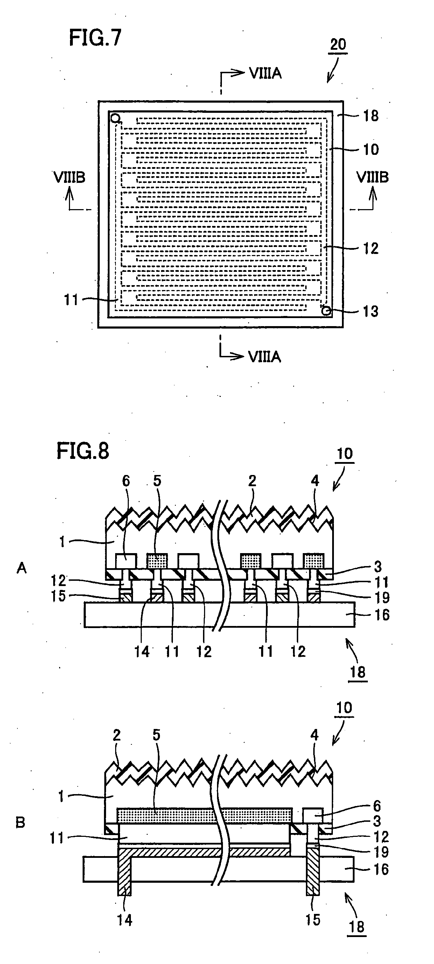

Fig. 7 is a plan view of a preferred embodiment of a solar cell of the present invention, as seen at its light receiving surface. Fig. 8A is a cross section taken along a line VIIIA-VIIIA of Fig. 7 and Fig. 8B is a cross section taken along a line VIIIB-VIIIB of Fig. 7. As shown in Fig. 7, the present invention provides solar cell 20 having interconnection substrate 18 and solar cell wafer 10 electrically connected. The present solar cell 20 is formed of solar cell wafer 10 and interconnection substrate 18.

Initially, solar cell 20 in a preferred embodiment will be described with reference to Fig. 8A and Fig. 8B.

Interconnection substrate 18 includes insulating substrate 16 and p interconnection 14 and n interconnection 15 provided on insulating substrate 16 at a surface closer to a light receiving surface. P interconnection 14 and n interconnection 15 are formed such that they are electrically insulated from each other. As shown in Fig. 8B, preferably, p interconnection 14 and n interconnection 15 are each passed through insulating substrate 16 via through holes and thus provided at a back surface of insulating substrate 16. P interconnection 14 and n interconnection 15 provided at the back surface function as an output extracting terminal. P interconnection 14 and n interconnection 15 provided at the back surface can simplify electrical connection at the back surface of insulating substrate 16. Furthermore, at the back surface, interconnection substrate 18 and solar cell wafer 10 are electrically connected by p interconnection 14 and p electrode 11 connected via solder 19 and n interconnection 15 and n electrode 12 connected via solder 19. Preferably, a p interconnection 14 forming pattern and the p electrode 11 forming pattern substantially overlay each other, and an n interconnection 15 forming pattern and the n electrode 12 forming pattern substantially overlay each other. Hereinafter, in the present invention, "substantially overlay" means that at least a pattern forming a p electrode and that forming an n electrode overlay a pattern forming a p interconnection and that forming an n interconnection, respectively, and the p interconnection and the n interconnection may have portions that do not overlay the p electrode and the n electrode, respectively. As such, the p electrode and the n electrode may be formed for example in the form of dots.

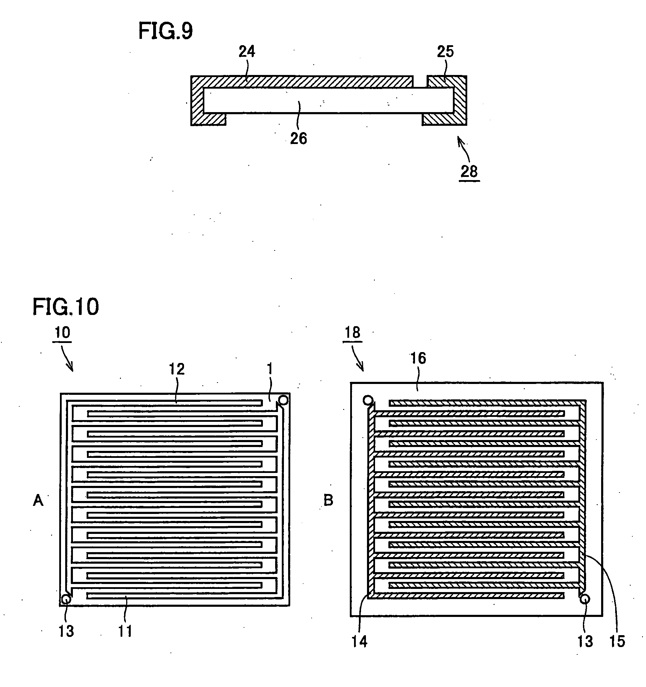

Fig. 9 is a cross section of another embodiment of the interconnection substrate of the present invention. In Fig. 8B interconnection substrate 18 has p interconnection 14 and n interconnection 15 each passed through insulating substrate 16 via a through hole and thus provided at a back surface of insulating substrate 16, whereas in Fig. 9 an interconnection substrate 28 has a p interconnection 24 and an n interconnection 25 each folded back at an end of an insulating substrate 26 and thus provided at a back surface of insulating substrate 26. In the present embodiment, interconnection substrate 28 is not required to have a through hole and can thus be more readily processed.

Furthermore, as shown in Fig 7, solar cell wafer 10 preferably has a back surface having p electrode 11 and n electrode 12 each in the form of a comb formed of an electrode in the form of a linear line and an electrode in the form of a plurality of teeth orthogonal to the linear electrode. P electrode 11 and n electrode 12 are formed to have their respective toothed electrodes facing each other, and p electrode 11 and n electrode 12 have their respective toothed electrodes provided alternately along one surface of the back surface of solar cell wafer 10. Furthermore, an alignment mark 13 is provided at both interconnection substrate 18 and solar cell wafer 10 for preventing interconnection substrate 18 and solar cell wafer 10 from having their connection displaced.

The p electrode and the p interconnection substantially overlay each other, and so do the n electrode and the n interconnection, preferably in such a pattern that for example for the p electrode and the n electrode in the form of combs, respectively, the combs have at least their respective toothed electrode forming patterns identically matching the p and n interconnection forming patterns.

In the present embodiment p interconnection 14 and p electrode 11 are connected using solder 19 and n interconnection 15 and n electrode 12 are connected using solder 19. Alternatively, solder 19 may be replaced with a conductive adhesive. The conductive adhesive can for example be Sn-Bi based solder melting at approximately 150°C, a silver paste that sets similarly at a low temperature of approximately 150°C, or the like.

Insulating substrate 16 can be implemented for example as a glass substrate, a glass epoxy substrate, a glass composite substrate, a paper epoxy substrate, a paper phenol substrate, polyethylene terephthalate (PET) film, polyethylene naphthalate (PEN) film, polyimide (PI) film or the like. More preferably, insulating substrate 16 is implemented as an approximately 0.5-2 mm glass substrate or glass epoxy substrate, as it can reinforcement thin, fragile solar cell wafer 10. Furthermore, p interconnection 14 and n interconnection 15 are preferably formed of a material including at least one of copper, aluminum and silver. For example they can be copper foil, aluminum foil, silver foil, these foils and Invar (Fe-Ni alloy) deposited in layers to provide metallic foil providing adjustment in thermal expansion, or conductive paste including at least one of copper, aluminum and silver or the like for example printed in a desired pattern on insulating substrate 16.

Solar cell wafer 10 is formed with semiconductor substrate 1, such as a silicon substrate, serving as a material. Solar cell wafer 10 is formed as semiconductor substrate 1 undergoes a variety of processes, as will be described hereinafter. Solar cell wafer 10 has a back surface provided with a plurality of p+ layers 5 and a plurality of n+ layers 6 alternately spaced. On p+ layer 5 and n+ layer 6 are deposited p electrode 11 and n electrode 12 in the form of combs, as has been described previously. P electrode 11 and n electrode 12 are formed preferably of metallic material, silver in particular. Furthermore, solar cell wafer 10 at its back surface other than a portion having p electrode 11 and n electrode 12 is covered with passivation film 3. Furthermore, solar cell wafer 10 has a light receiving surface having texture structure 4 and covered with antireflection film 2.

Fig. 10A is a plan view of a preferred embodiment of a solar cell wafer of the present invention, as seen at its back surface, and Fig. 10B is a plan view of a preferred embodiment of an interconnection substrate of the present invention, as seen at its light receiving surface. The Fig. 10A p electrode 11 and n electrode 12 forming patterns are in the form of combs, respectively, as has been described previously, and preferably have a structure mirroring the Fig. 10B p interconnection 14 and n interconnection 15 forming patterns. In other words, preferably, when interconnection substrate 18 and solar cell wafer 10 are connected, p interconnection 14 and p electrode 11 forming patterns, and n interconnection 15 and n electrode 12 forming patterns identically match, and preferably, alignment mark 13 is provided at interconnection substrate 18 and solar cell wafer 10 for preventing interconnection substrate 18 and solar cell wafer 10 from having their connection displaced.

Herein, a conventional back surface contact solar cell wafer, as well as solar cell 20 of the present embodiment, has a p electrode deposited on a p+ layer and an n electrode deposited on an n+ layer. In the conventional back surface contact solar cell wafer the p electrode and the n electrode have a role of suppressing a series resistance component. Accordingly, the p electrode and the n electrode need to be formed with a line width increased to a limit at which the p electrode and the n electrode do not contact. In the present embodiment, in contrast, solar cell 20 has the p electrode 11 and n electrode 12 forming patterns identically matching the p interconnection 14 and n interconnection 15 forming patterns, respectively, and the role of suppressing the series resistance component will be played by p interconnection 14 and n interconnection 15. P electrode 11 and n electrode 12 are only required for electrical connection to p interconnection 14 and n interconnection 15, respectively. Accordingly, p electrode 11 and n electrode 12, as finished, having a thickness of several µm suffice, and can have a line width smaller than conventional. As a result, p electrode 11 and n electrode 12 can be formed with a metallic material used in an amount of approximately one tenth of that conventionally used, and solar cell 20 can be fabricated inexpensively. In particular, if p electrode 11 and n electrode are formed with a metallic material of an expensive silver material and p interconnection 14 and n interconnection 15 are formed for example with copper, and they are connected using solder, a large cost reduction can be achieved and the silver material can also be efficiently utilized as a source.

Furthermore, as has been described previously, a conventional back surface contact solar cell wafer has a p electrode and an n electrode on a solar cell wafer across substantially the entirety of the back surface as thick as possible. This causes the solar cell wafer to experience a stress attributed to the electrodes, and for a semiconductor substrate equal to or smaller than 200 µm, the solar cell wafer significantly warps, which makes it difficult to fabricate a solar cell. In the present embodiment, as has been described previously, solar cell 20, as can be seen from that p electrode 11 and n electrode 12 can be formed with a metallic material used in an amount of approximately one tenth of that conventionally used, has p electrode 11 and n electrode 12 formed to be smaller in thickness than conventional. This can reduce warpage of solar cell wafer 10, and semiconductor substrate 1 can have a thickness set to be equal to or smaller than 200 µm, and can be reduced in thickness to 100 µm. Semiconductor substrate 1 reduced in thickness allows an expensive silicon material to be used in a reduced amount. Furthermore in accordance with the present invention solar cell 20 can have the p interconnection and the n interconnection adjusted in thickness to sufficiently reduce the solar cell's interconnection resistance. Thus, if the electrode is formed with a small amount of metallic material, a high F.F value can nonetheless be achieved.

While the present embodiment has been described with solar cell wafer 10 of a back surface contact type as an example, the present invention is not limited thereto, and it may be any solar cell wafer of a back surface electrode type that has a back surface having a p electrode and an n electrode.

### [Method of Fabricating Solar Cell Wafer]

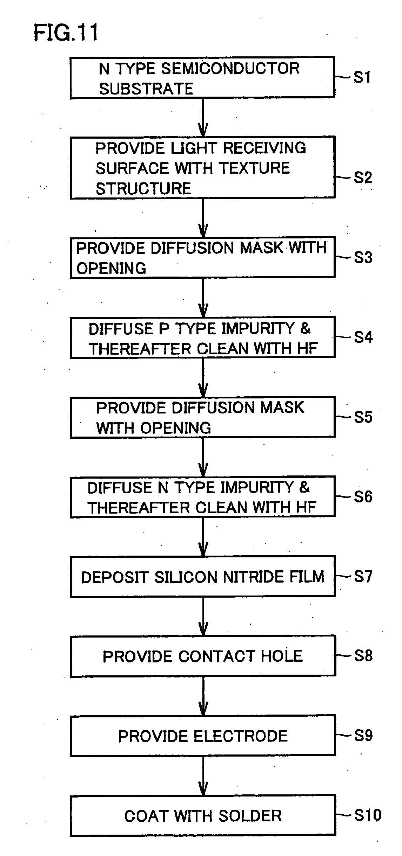

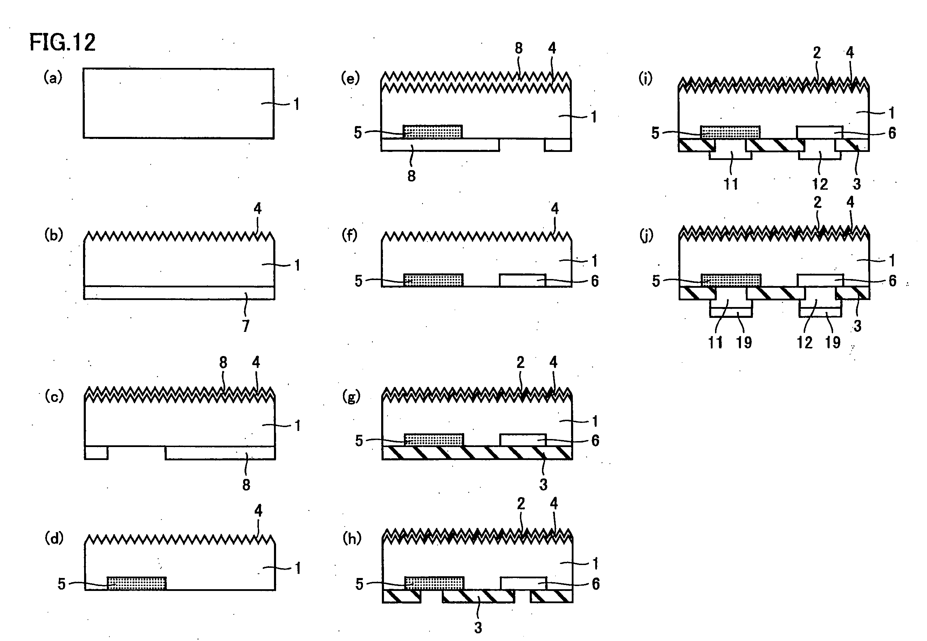

Fig. 11 represents a process of a method of fabricating a solar cell wafer of the present invention in one embodiment. Fig. 12 is a cross section for illustrating each step of the process of the method of fabricating the solar cell wafer of the present invention in one embodiment. Fig. 11 indicates step 1 (S1) to step 10 (S 10), which correspond to Figs. 12(a)-12(j), respectively. For the sake of illustration, Fig. 12 shows a silicon substrate having a back surface provided with only a single n+ layer and only a single p+ layer. In reality, a plurality of such layers can be provided. Hereinafter for each step indicated in Fig. 11a method of fabricating solar cell wafer 10 will be described with reference to Fig. 12.

### <S1: N Type Semiconductor Substrate>

As shown in Fig. 12(a), semiconductor substrate 1 such as an n type silicon substrate is prepared. Semiconductor substrate 1 for example has removed damage caused when it was sliced. More specifically, semiconductor substrate 1 has such damage removed by etching a surface of semiconductor substrate 1 with a mixed acid of an aqueous solution of hydrogen fluoride and nitric acid, an alkaline aqueous solution of sodium hydroxide or the like, or the like. Semiconductor substrate 1 is not particularly limited in size and geometry. For example, it can be a square having a thickness equal to or larger than 100 µm and equal to or smaller than 300 µm, and sides each of equal to or larger than 100 mm and equal to or smaller than 200 mm.

### <S2: Providing Light Receiving Surface with Texture Structure>

As shown in Fig 12(b), semiconductor substrate 1 is provided at the back surface with a texture mask 7 formed of silicon oxide film by atmospheric pressure CVD, and thereafter semiconductor substrate 1 is provided at the light receiving surface with texture structure 4. The light receiving surface can be provided with texture structure 4 by etching semiconductor substrate 1 provided with texture mask 7 with etchant. The etchant can for example be an alkaline aqueous solution of sodium hydroxide, potassium hydroxide or the like with isopropyl alcohol added thereto, that is heated to a temperature equal to or higher than 70°C and equal to or lower than 80°C. After texture structure 4 is formed, texture mask 7 on the back surface of semiconductor substrate 1 is removed with an aqueous solution of hydrogen fluoride or the like.

### <S3: Providing Diffusion Mask with Opening>

As shown in Fig 12(c), semiconductor substrate 1 is provided at the light receiving surface and the back surface with a diffusion mask 8, and diffusion mask 8 on the back surface is provided with an opening. More specifically, initially, semiconductor substrate 1 is provided at the light receiving surface and the back surface with silicon oxide film deposited by atmospheric pressure CVD to serve as diffusion mask 8. An etching paste is applied on diffusion mask 8 of the back surface of semiconductor substrate 1 at a location to be provided with an opening. Semiconductor substrate 1 can then be heated and subsequently cleaned to remove the residue of the etching paste therefrom to provide diffusion mask 8 with the opening. Note that the opening is provided at a portion corresponding to the location of p+ layer 5 described later. Furthermore, the etching paste contains an etching component for etching diffusion mask 8.

### <S4: Diffusing P Type Impurity and Subsequently Cleaning with HF>

As shown in Fig 12(d), a p type impurity is diffused and thereafter diffusion mask 8 provided in S3 is cleaned with an aqueous solution of hydrogen fluoride (HF) or the like to provide p+ layer 5 serving as a conductive impurity diffusion layer. Initially, vapor phase diffusion using BBr₃ is for example employed to diffuse a p type impurity as a conductive impurity in semiconductor substrate 1 at an exposed back surface. After the diffusion, semiconductor substrate 1 has diffusion mask 8 on the light receiving surface and the back surface, boron silicate glass (BSG) provided as boron is diffused, and the like all removed therefrom with an aqueous solution of hydrogen fluoride or the like.

### <S5: Providing Diffusion Mask with Opening>

As shown in Fig 12(e), semiconductor substrate 1 is provided at the light receiving surface and the back surface with diffusion mask 8, and diffusion mask 8 on the back surface is provided with an opening. This step is similar to S3. Note, however, that in S5, diffusion mask 8 is provided with the opening at a portion corresponding to the location of n+ layer 6 described later.

### <S6: Diffusing N Type Impurity and Subsequently Cleaning with HF>

As shown in Fig 12(f), an n type impurity is diffused and thereafter diffusion mask 8 provided in S5 is cleaned with an aqueous solution of hydrogen fluoride or the like to provide n+ layer 6 serving as a conductive impurity diffusion layer. Initially, vapor phase diffusion using POCl₃ is for example employed to diffuse an n type impurity as a conductive impurity in semiconductor substrate 1 at an exposed back surface. After the diffusion, semiconductor substrate 1 has diffusion mask 8 on the light receiving surface and the back surface, phosphorus silicate glass (PSG) provided as phosphorus is diffused, and the like all removed therefrom with an aqueous solution of hydrogen fluoride or the like.

### <S7: Depositing Silicon Nitride Film>

As shown in Fig 12(g), semiconductor substrate 1 is provided at the light receiving surface with silicon nitride film to serve as antireflection film 2, and at the back surface with silicon nitride film to serve as passivation film 3. Initially, semiconductor substrate 1 is provided at the back surface for example with silicon nitride film having an index of refraction of 2.6-3.6 to serve as passivation film 3. Then, semiconductor substrate 1 is provided at the light receiving surface for example with silicon nitride film having an index of refraction of 1.9-2.1 to serve as antireflection film 2. The silicon nitride film can be deposited for example by plasma CVD.

### <S8: Providing a Contact Hole>

As shown in Fig 12(h), p+ layer 5 and n+ layer 6 are partially exposed. To do so, semiconductor substrate 1 has passivation film 3 removed partially on the back surface to provide a contact hole. The contact hole can be provided for example by using the aforementioned etching paste.

### <S9: Depositing Electrodes>

As shown in Fig 12(i), p electrode 11 and n electrode 12 are deposited in contact with the exposed surface of p+ layer 5 and that of n+ layer 6, respectively, for example by printing silver paste along the contact hole's surface through a screen or in an ink jet system and subsequently firing it. This provides p electrode 11 and n electrode 12 formed of silver making a contact with semiconductor substrate 1.

### <S10: Coating with Solder>

As shown in Fig 12(j), p electrode 11 and n electrode 12 are immersed in a solder bath to have a surface coated with solder 19. Solder 19 may be replaced with conductive adhesive to coat the electrodes.

Herein, preferably, p+ layer 5 and n+ layer 6 are each formed in the form of a comb having one linear side and a toothed portion formed of a plurality of straight lines perpendicular to the linear side. Preferably, p+ layer 5 and n+ layer 6 have their respective toothed portions facing each other with their respective teeth alternating along a single surface.

Furthermore, the present embodiment has been described with semiconductor substrate 1 of n type. Alternatively, semiconductor substrate 1 may be of p type. If semiconductor substrate 1 is of n type, p+ layer 5 provided to semiconductor substrate 1 at the back surface and semiconductor substrate 1 provide the back surface with a pn junction. If semiconductor substrate 1 is of p type, n+ layer 6 provided to semiconductor substrate 1 at the back surface and semiconductor substrate 1 of p type provide the back surface with a pn junction. Furthermore, if semiconductor substrate 1 is a silicon substrate, then, for example, polycrystalline silicon or monocrystalline silicon or the like can be used. Furthermore, as has been described previously, the present solar cell wafer can have p electrode 11 and n electrode 12 with a thickness of approximately several µm, and the electrodes can be printed in an ink jet system. Printing in the ink jet system exerts on semiconductor substrate 1 a load smaller than printing through a screen does. This can further reduce cracking of solar cell wafer 10. Solar cell wafer 10 thus completes.

In the present embodiment, a back surface contact solar cell wafer 10 has been exemplified to describe a method of fabricating a solar cell wafer. However, the present method of fabricating a solar cell wafer is not limited thereto, and it may be any solar cell wafer of a back surface electrode type having a back surface having a p electrode and an n electrode.

### [Method of Fabricating Solar Cell]

Hereinafter, reference will be made to Fig. 10A and Fig. 10B to describe a method of fabricating a solar cell formed of solar cell wafer 10 and interconnection substrate 18. Initially, insulating substrate 16 having a light receiving surface provided thereon with p interconnection 14 and n interconnection 15 is prepared as interconnection substrate 18. P interconnection 14 and n interconnection 15 are preferably formed of a material including at least one of copper, aluminum and silver. P interconnection 14 and n interconnection 15 can be formed for example of any of copper foil, aluminum foil or silver foil of a thickness equal to or larger than 10 µm deposited on insulating substrate 16 and etched. They may be formed for example of a conductive paste containing at least one of copper, aluminum and silver and for example printed in a desired pattern. Herein, as well as the solar cell wafer 10 p electrode 11 and n electrode 12, interconnection substrate 18 preferably has p interconnection 14 and n interconnection 15 in the form of combs, respectively, with their respective teeth facing each other.

P interconnection 14 and n interconnection 15 thus formed may have a surface coated with solder. Coating with solder may be done similarly as has been described for the method of fabricating solar cell wafer 10: it may be done by immersing interconnection substrate 18 in a solder bath or by printing cream solder.

Interconnection substrate 18 is then disposed on solar cell wafer 10 at the back surface, and as shown in Fig. 8A and Fig. 8B, p interconnection 14 and n interconnection 15 are disposed on p electrode 11 and n electrode 12, respectively. Subsequently, solar cell wafer 10 and interconnection substrate 18 are electrically connected in a process employing a reflow furnace and using solder or using a conductive adhesive to complete solar cell 20. Herein, connecting solar cell wafer 10 to interconnection substrate 18 that has sufficient strength can effectively reinforce solar cell 20, and when a thin silicon substrate or the like is used as semiconductor substrate 1, an effect preventing a cell from cracking can also be expected.

Herein, when a reflow furnace is used to provide connection using solder, it is expected that the solder's surface tension caused as it melts effectively provides movement to a precise position to be connected (i.e., a self alignment effect). However, a conventional solar cell wafer has a p electrode and an n electrode formed in dots, and when it is loaded in the reflow furnace, it is vibrated and thus occasionally offset relative to the interconnection substrate in angle θ and the directions of the x and y axes. Note that herein, the x and y axes are orthogonal to each other. The p electrode and the n electrode exist alternately with a small spacing therebetween, and if the solar cell wafer and the interconnection substrate are only slightly offset, for example the p electrode and the n interconnection contact or the like, occasionally resulting in a solar cell having a significantly impaired characteristic. The present invention can provide solar cell wafer 20 having p electrode 11 and n electrode 12 in the form of combs and identical in geometry to p interconnection 14 and n interconnection 15 to prevent the solar cell wafer and the interconnection substrate from being offset when they are bonded together using solder.

Note that p interconnection 14 and p electrode 11 may be connected together using conductive adhesive, rather than solder, and so may n interconnection 15 and n electrode 12.

### [Solar Cell Module]

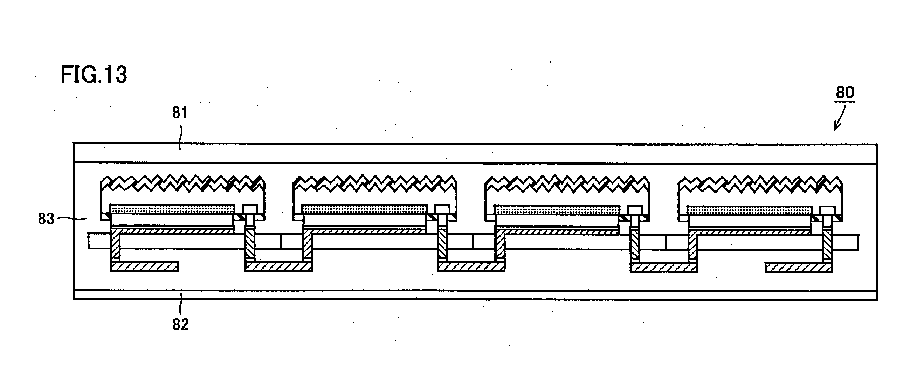

Fig. 13 is a cross section of a preferred embodiment of a solar cell module of the present invention. As shown in Fig 13, a solar cell module 80 corresponds for example to the Fig. 4 second solar cell array that is sandwiched by resin 83 and thereafter has a light receiving surface protected by a member implemented as a glass substrate 81 and a back surface protected by a member implemented as a weatherproof film 82 to seal it. Preferably, resin 83 is ethylene-vinyl acetate copolymer (EVA) resin or a similar, transparent thermoplastic resin. Solar cell module 80 has high durability. In Fig. 13, the solar cell module has been described with a solar cell array similar to that shown in Fig. 4. However, it is not limited thereto: the present solar cell module is formed of any of the present solar cell, first solar cell array, second solar cell array and third solar cell array sealed in the method as described above.

The solar cell module fabricated in the present invention is formed of the first to third solar cell arrays such that the strings are interconnected by an interconnector that is connected at a back surface of an interconnection substrate. This can eliminate the necessity of providing a space for connecting the strings. The solar cell module can thus have solar cell wafers packed more densely and as a result high module conversion efficiency can be achieved. Furthermore, the string connecting interconnector that is provided at the back surface of the interconnection substrate can be designed with an increased degree of freedom and thus have a sufficient width so that when the solar cell module is fabricated, reduced F.F can be prevented and a module with high conversion efficiency can be fabricated.

### Examples

Hereinafter the present invention will more specifically be described with reference to examples, although the present invention is not limited thereto.

### <First Example>

First, a solar cell wafer is fabricated in a procedure indicated below in accordance with the Fig. 11 process.

### <S1>

An n type silicon substrate having each side of 100 mm and a thickness of 200 µm is prepared. The silicon substrate, having damage caused when it was sliced, has it removed with an alkaline solution.

### <S2>

Then, an aqueous solution of sodium hydroxide with isopropyl alcohol added thereto in a small amount was heated to 80°C to provide an etching alkaline solution. The etching alkaline solution is used to etch the silicon substrate at the light receiving surface to form a texture structure. Note that before it is etched the silicon substrate has its back surface undergoing atmospheric pressure CVD to have a texture mask implemented as silicon oxide film deposited thereon for protection against etching. Then a laser marker is used to provide the silicon substrate at the back surface with an alignment mark used in a subsequent step, and an aqueous solution of hydrogen fluoride is used to once remove the silicon oxide film deposited on the silicon substrate at the back surface.

### <S3>

Subsequently, the silicon substrate is provided at both the light receiving surface and the back surface with a diffusion mask of a 250 nm silicon oxide film deposited by atmospheric pressure CVD. With the alignment mark considered, an etching paste containing phosphoric acid as a main component is printed on the silicon oxide film of the back surface of the silicon substrate in accordance with a desired p+ layer forming pattern. Subsequently, the silicon substrate is heated to 320°C and washed with water to form a window for performing p+ diffusion in the silicon oxide film.

### <S4>

Then in an ambient of 1000°C vapor phase diffusion using BBr₃ is performed for 60 minutes to deposit a p+ layer at the window of the back surface of the silicon substrate to serve as a conductive impurity diffusion layer. Subsequently, the silicon oxide film of the light receiving surface and back surface of the silicon substrate and boron silicate glass (BSG) provided as boron was diffused are all removed using an aqueous solution of hydrogen fluoride.

### <S5>

Then, atmospheric pressure CVD is performed to provide the silicon substrate at the opposite surfaces again with silicon oxide film deposited to be 250 nm and serve as a diffusion mask. Then, with the alignment mark considered, an etching paste containing phosphoric acid as a main component is printed on the silicon oxide film of the back surface of the silicon substrate in accordance with a desired n+ layer forming pattern. Subsequently, the silicon substrate is heated to 320°C and washed with water to form a window for performing n+ diffusion in the silicon oxide film.

### <S6>

Then in an ambient of 900°C vapor phase diffusion using POCl₃ is performed for 30 minutes to deposit an n+ layer at the window of the back surface of the silicon substrate to serve as a conductive impurity diffusion layer. Subsequently, the silicon oxide film of the light receiving surface and back surface of the silicon substrate and phosphorus silicate glass (PSG) provided as phosphorus was diffused are all removed using an aqueous solution of hydrogen fluoride.

### <S7>

Then, plasma CVD is employed to provide the silicon substrate at the back surface with passivation film implemented as silicon nitride film having an index of refraction of 3. The silicon substrate is provided at the light receiving surface with an antireflection film implemented as silicon nitride film having an index of refraction of 2 and a thickness of 70 nm.

### <S8>

Then, an etching paste containing phosphoric acid as a main component is printed on the n+ layer and the p+ layer in a desired pattern. Then the silicon substrate is heated at 250°C and washed with water to provide the passivation film with a contact hole.

### <S9>

Then, silver paste is printed in a form corresponding to the pattern forming the contact hole and is then fired to provide a p electrode and an n electrode.

### <S10>

The p electrode and the n electrode are immersed in a solder bath to be coated with solder.

Herein the p electrode and the n electrode are formed in the form of combs, respectively, and have their respective toothed electrodes facing each other with their respective teeth disposed alternately. Furthermore, the p electrode and the n electrode are both approximately 4 µm for height and approximately 200 µm for all widths.

By the above operation, the solar cell wafer is fabricated. Then, an interconnection substrate is fabricated.

Initially, a glass epoxy substrate in the form of a square having each side of 100.5 mm and a thickness of 1.2 mm is prepared as an insulating substrate. Then, the insulating substrate has one surface provided with a p interconnection and an n interconnection formed of 35 µm thick copper to provide an interconnection substrate. The p interconnection and the n interconnection are formed to overlay the p electrode and n electrode forming patterns to mach them. Furthermore, an alignment mark that does not interfere with the p interconnection and the n interconnection is provided to prevent the substrate from having displaced connection to a solar cell wafer in a subsequent step. Furthermore, the p interconnection and the n interconnection are passed through the insulating substrate via through holes and thus also provided at the back surface of the insulating substrate for extracting electric power. Subsequently, the p interconnection and the n interconnection are immersed in a solder bath to be coated with solder. By the above operation, the interconnection substrate is fabricated.

Then the alignment mark on the solar cell wafer and that on the interconnection substrate are utilized to register the p electrode and the n electrode on the p interconnection and the n interconnection to superimpose the solar cell wafer on the interconnection substrate. The intermediate product is then loaded into a reflow furnace. It is heated preliminarily to 100°C and then primarily to 200°C and the solar cell wafer and the interconnection substrate are electrically connected to complete a solar cell.

The solar cell provides a short circuit current density Jsc (mA/cm²), an open circuit voltage Voc (V), and a Fill Factor (F.F) value, as shown in table 1.

### <First Comparative Example>

Fig. 15 is a plan view of a conventional solar cell wafer serving as a first comparative example, as seen at its back surface. A solar cell wafer 90 is fabricated to be similar to the first example of the present invention except that the former has a p electrode 71 and an n electrode 72 formed to have a height of approximately 20 µm and have their respective toothed electrodes having a width of approximately 400 µm, and a bus bar electrode has a width of 1 mm. Note that the height and the width have values, respectively, larger than those in the first example of the present invention because conventionally, such height and width are set at values as large as possible to reduce a series resistance component applied to the electrodes.

As shown in Fig 15, solar cell wafer 90 has an interconnector 77 connected to a bus bar electrode without using an interconnection substrate, and is thus measured for Jsc, Voc, F.F, as done in the first example of the present invention, as shown in table 1.

As indicated in table 1, the first example of the present invention and the first comparative example exhibit a large difference in F.F. It can thus be seen that p electrode 71 and n electrode 72 alone cannot suppress series resistance component sufficiently. Furthermore in the first comparative example p electrode 71 and n electrode 72 cannot be formed to be thicker than this, since thicker electrodes cause the solar cell wafer to significantly warp. It has been found that while the present solar cell has a p electrode and an n electrode formed with silver used in an amount smaller than the first comparative example, the former has a significantly improved solar cell wafer characteristic in comparison with the latter.

**Table 1**

| | Isc (A) | Voc (V) | F.F |
|---|---|---|---|
| Present 1st Example | 3.75 | 0.642 | 0.801 |
| 1st Comparative Example | 3.76 | 0.640 | 0.758 |

### <Second Example>

Initially, a glass epoxy substrate in the form of a square having each side of 100.5 mm and a thickness of 1.2 mm is prepared as an insulating substrate. Then, the insulating substrate has one surface provided with a p interconnection and an n interconnection formed of 35 µm thick copper to provide an interconnection substrate. Furthermore, an alignment mark that does not interfere with the p interconnection and the n interconnection is provided to prevent the substrate from having displaced connection to a solar cell wafer in a subsequent step. Furthermore, the p interconnection and the n interconnection are passed through the insulating substrate via through holes and thus also provided at the back surface of the insulating substrate for extracting electric power. Subsequently, the p interconnection and the n interconnection are immersed in a solder bath to be coated with solder.

A solar cell wafer in the form or a square having each side of 100 mm and a thickness of 200 µm and having a p electrode and an n electrode formed to overlay the p interconnection and n interconnection forming patterns to identically match them, is prepared in a method similar to that described in the first example of the present invention. Then the alignment marks are utilized to register the p electrode and the n electrode on the p interconnection and the n interconnection, respectively, to superimpose the solar cell wafer on the interconnection substrate. The intermediate product is then loaded into a reflow furnace. It is heated preliminarily to 100°C and then primarily to 200°C and the solar cell wafer and the interconnection substrate are electrically connected to complete a solar cell. The p electrode, the n electrode, the p interconnection and the n interconnection all have a line width of 200 µm.

A p interconnection of a back surface of an insulating substrate of one solar cell thus completed is connected to an n interconnection of a back surface of an insulating substrate of another solar cell by an interconnector to connect four solar cells in series. A second solar cell array in the form of a string formed of four solar cells is thus formed. Four second solar cell arrays each in the form of a similar string are prepared. A p interconnection of a back surface of an insulating substrate of one second solar cell array in the form of the string is connected to an n interconnection of a back surface of an insulating substrate of another second solar cell array in the form of the string by an interconnector. The four second solar cell arrays are thus connected to consequently connect 16 solar cells in series. Subsequently, EVA resin and glass, weatherproof film are used to seal the second solar cell arrays to fabricate a solar cell module. The solar cell module has an area of 420 mm × 420 mm.

The solar cell module has the solar cells connected by an interconnector of solder coated copper foil having a thickness of 20 µm and an area of 90 mm × 5 mm and has the second solar cell arrays in the form of the strings connected by an interconnector of solder coated copper foil having a thickness of 20 µm and an area of 30 mm × 190 mm. This solar cell module provides a short circuit current Isc (A), an open circuit voltage Voc (V), and a fill factor (F.F) value, as shown in table 2. As shown in table 2, for F.F in particular, while the module has 16 solar cells connected, it provides a value comparable to that for a single solar cell.

### <Second Comparative Example>

Fig. 16 is a plan view of a conventional solar cell array serving as a second comparative example, as seen at its back surface. As shown in Fig. 16, the first comparative example's solar cell wafer 90 is used, and no interconnection substrate is used and only interconnector 77 is used to prepare four strings each having four solar cell wafers 90 connected in series and further connect the four strings in series to fabricate a conventional solar cell array. This solar cell array is sealed with EVA resin and glass, weatherproof film to fabricate a conventional solar cell module. The solar cell module has an area of 420 mm × 420 mm. The string is fabricated by interconnecting solar cell wafers 90 by interconnector 77, which is identical to that used in the second example of the present invention, having a thickness of 20 µm and an area of 90 mm × 5 mm, as a relation with the solar cell module's area is considered. Furthermore, the strings are interconnected by interconnector 77, which has a thickness of 20 µm and an area of 5 mm × 190 mm as a relation with the solar cell module's area is considered. The solar cell module is measured for short circuit current Isc (A), open circuit voltage Voc (V), and fill factor (F.F) in a method similar to that in the second example of the present invention, as shown in table 2. Note that "conversion efficiency" indicates "module efficiency".

The second comparative example provides an F.F further lower than the first comparative example. It is considered that this is attributed to that the strings are interconnected by interconnector 77 smaller in area than that used in the second example of the present invention to interconnect the second solar cell arrays in the form of strings. It is considered that the second comparative example with an interconnector similar in form to that used in the second example of the present invention would be improved in F.F. However, such would increase the solar cell module in area, and as a result it is expected that the second comparative example's solar cell module would be impaired in conversion efficiency. If the present solar cell module has strings interconnected by an interconnector large in width (or area in cross section) it can still have solar cells packed densely relative thereto, and the present solar cell module thus exhibits that it can achieve an F.F higher than conventional and as a result, high module efficiency.

**Table 2**

| | Isc (A) | Voc (V) | F.F | Conversion Efficiency |
|---|---|---|---|---|
| Present 2nd Example | 3.78 | 10.3 | 0.795 | 17.5% |
| 2nd Comparative Example | 3.81 | 10.2 | 0.744 | 16.4% |

It should be understood that the embodiments and examples disclosed herein are illustrative and non-restrictive in any respect. The scope of the present invention is defined by the terms of the claims, rather than the description above, and is intended to include any modifications within the scope and meaning equivalent to the terms of the claims.

## Claims

1. A first solar cell array (30) comprising:
a solar cell wafer (10) including a semiconductor substrate (1) and a p electrode (11) and an n electrode (12) provided at a surface of said semiconductor substrate (1);
an interconnection substrate (38) including an insulating substrate (36) having a light receiving surface and a p interconnection (34) and an n interconnection (35) provided at said light receiving surface and electrically insulated from each other,
on said interconnection substrate (38), more than one said solar cell wafer (10) being disposed adjacently,
said p interconnection (34) and said n interconnection (35) being provided at said surface of said insulating substrate (36) to correspond in number to said solar cell wafer (10) disposed,
said p electrode (11) and said p interconnection (34) being electrically connected, said n electrode (12) and said n interconnection (35) being electrically connected; and
an interconnection that includes an interconnection (32) formed such that said p interconnection (34) electrically connected to one said solar cell wafer (10) and said n interconnection (35) electrically connected to another said solar cell wafer (10) adjacent to said one solar cell wafer (10) are electrically connected and that is formed such that said p interconnection (34) and said n interconnection (35) are also provided at a surface of said insulating substrate (36) opposite to said light receiving surface and electrically connected at said surface opposite.

2. The first solar cell array (30) according to claim 1, comprising an interconnection formed such that said p interconnection (34) and said n interconnection (35) are at least partially passed through said insulating substrate (36) via a through hole and thus provided at said surface of said insulating substrate (36) opposite to said light receiving surface, and electrically connected at said surface opposite.

3. The first solar cell array (30) according to claim 1, wherein:
said p interconnection (34) and said n interconnection (35) are formed of a material including at least one of copper, aluminum and silver; and
said p electrode (11) and said p interconnection (34) are connected using one of solder (39) and a conductive adhesive and so are said n electrode (12) and said n interconnection (35).

4. The first solar cell array (30) according to claim 1, wherein:
a pattern forming said p electrode (11) substantially overlays a pattern forming said p interconnection (34) when said pattern forming said p electrode (11) and said pattern forming said p interconnection (34) are electrically connected; and
a pattern forming said n electrode (12) substantially overlays a pattern forming said n interconnection (35) when said pattern forming said n electrode (12) and said pattern forming said n interconnection (35) are electrically connected.

5. A second solar cell array (40) comprising:
a plurality of solar cells (20) disposed adjacently, each formed of a single solar cell wafer (10) including a semiconductor substrate (1) and a p electrode (11) and an n electrode (12) provided at a surface of said semiconductor substrate (1), and a single interconnection substrate (18) including an insulating substrate (16) having a light receiving surface and a p interconnection (14) and an n interconnection (15) provided at said light receiving surface and electrically insulated from each other, said p electrode (11) and said p interconnection (14) being electrically connected, said n electrode (12) and said n interconnection (15) being electrically connected; and
an interconnection that includes an interconnection formed such that said p interconnection (14) of one said solar cell (20) and said n interconnection (15) of said solar cell (20) adjacent to said one solar cell (20) are electrically connected and that is formed such that said p interconnection (14) and said n interconnection (15) are electrically connected at said surface opposite of said insulating substrate (16).

6. The second solar cell array (40) according to claim 5, comprising an interconnection formed such that said p interconnection (14) and said n interconnection (15) of said solar cell (20) pass through said insulating substrate (16) via a through hole and are thus provided at said surface of said insulating substrate (16) opposite to said light receiving surface, and electrically connected at said surface opposite of said insulating substrate (16).

7. The second solar cell array (40) according to claim 5, wherein:
said p interconnection (14) and said n interconnection (15) are formed of a material including at least one of copper, aluminum and silver; and
said p electrode (11) and said p interconnection (14) are connected using one of solder (19) and a conductive adhesive and so are said n electrode (12) and said n interconnection (15).

8. The second solar cell array (40) according to claim 5, wherein said solar cell (20) is provided such that:
a pattern forming said p electrode (11) substantially overlays a pattern forming said p interconnection (14) when said pattern forming said p electrode (11) and said pattern forming said p interconnection (14) are electrically connected; and
a pattern forming said n electrode (12) substantially overlays a pattern forming said n interconnection (15) when said pattern forming said n electrode (12) and said pattern forming said n interconnection (15) are electrically connected.

9. A third solar cell array (50) comprising:
first solar cell arrays (30) of claim 1 disposed adjacently; and
an interconnection (32) formed such that a p interconnection (34) of one said first solar cell array (30) and an n interconnection (35) of said first solar cell array (30) adjacent to said one first solar cell array (30) are electrically connected.

10. A third solar cell array (50) comprising:
first solar cell arrays (30) of claim 2 disposed adjacently; and
an interconnection formed such that a p interconnection (34) of one said first solar cell array (30) and an n interconnection (35) of said first solar cell array (30) adjacent to said one first solar cell array (30) are electrically connected at said surface opposite of said insulating substrate (36).

11. A solar cell (20) comprising:
a solar cell wafer (10) including a semiconductor substrate (1) and a p electrode (11) and an n electrode (12) provided at a surface of said semiconductor substrate (1); and
an interconnection substrate (18) including an insulating substrate (16) having a light receiving surface and a p interconnection (14) and an n interconnection (15) provided at said light receiving surface and electrically insulated from each other,
said p electrode (11) and said p interconnection (14) being electrically connected at said light receiving surface of said insulating substrate (16), said n electrode (12) and said n interconnection (15) being electrically connected at said light receiving surface of said insulating substrate (16),
said p interconnection (14) and said n interconnection (15) being also provided at a surface of said insulating substrate (16) opposite to said light receiving surface.

12. The solar cell (20) according to claim 11, wherein said p interconnection (14) and said n interconnection (15) pass through said insulating substrate (16) via a through hole and are thus provided at said surface of said insulating substrate (16) opposite to said light receiving surface.

13. The solar cell (20) according to claim 11, wherein:
said p interconnection (14) and said n interconnection (15) are formed of a material including at least one of copper, aluminum and silver; and
said p electrode (11) and said p interconnection (14) are electrically connected using one of solder (19) and a conductive adhesive and so are said n electrode (12) and said n interconnection (15).

14. The solar cell (20) according to claim 11, wherein:
a pattern forming said p electrode (11) substantially overlays a pattern forming said p interconnection (14) when said pattern forming said p electrode (11) and said pattern forming said p interconnection (14) are electrically connected; and
a pattern forming said n electrode (12) substantially overlays a pattern forming said n interconnection (15) when said pattern forming said n electrode (12) and said pattern forming said n interconnection (15) are electrically connected.

15. The solar cell (20) according to claim 11, wherein:
a pattern forming said p electrode (11) and a pattern of said p interconnection (14) formed at said light receiving surface of said insulating substrate (16) are identical; and
a pattern forming said n electrode (12) and a pattern of said n interconnection (15) formed at said light receiving surface of said insulating substrate (16) are identical.

16. The solar cell (20) according to claim 11, wherein said p electrode (11) and said n electrode (12) are provided at one surface of said solar cell wafer (10).

17. The solar cell (20) according to claim 16, wherein:
said p electrode (11) and said n electrode (12) are formed in a pattern such that said p electrode (11) and said n electrode (12) are formed in combs, respectively, each having one linear electrode and a toothed electrode having a plurality of teeth intersecting said linear electrode perpendicularly and said p electrode (11) and said n electrode (12) have their respective toothed electrodes facing each other, with their respective teeth arranged along one surface of said semiconductor substrate (1) alternately.

18. The solar cell (20) according to claim 11, wherein said semiconductor substrate (1) is a silicon substrate having a thickness equal to or smaller than 200 µm.

19. A method of fabricating the first solar cell array (30) of claim 3, employing a reflow furnace for connection using one of said solder (39) and said conductive adhesive.

20. A method of fabricating the second solar cell array (40) of claim 7, employing a reflow furnace for connection using one of said solder (19) and said conductive adhesive.

21. A solar cell module (80) formed of the first solar cell array (30) of claim 1 sealed with resin (83) and a protection substrate.

22. A solar cell module (80) formed of the second solar cell array (40) of claim 5 sealed with resin (83) and a protection substrate.

23. A solar cell module (80) formed of the third solar cell array (50) of claim 9 sealed with resin (83) and a protection substrate.

24. A solar cell module (80) formed of the third solar cell array of claim 10 sealed with resin (83) and a protection substrate.

25. A solar cell module (80) formed of the solar cell (20) of claim 11 sealed with resin (83) and a protection substrate.
